Europäisches Patentamt

European Patent Office

Office européen des brevets

(11) Numéro de publication: **0 309 332 B1**

## (12) FASCICULE DE BREVET EUROPEEN

(45) Date de publication de fascicule du brevet: **04.11.92**

(51) Int. Cl.⁵: **H03L 7/06**, H03L 1/02

(21) Numéro de dépôt: **88402365.6**

(22) Date de dépôt: **20.09.88**

(54) **Oscillateur à quartz asservi en fréquence par effet thermique.**

(30) Priorité: **22.09.87 FR 8713056**

(43) Date de publication de la demande:
**29.03.89 Bulletin 89/13**

(45) Mention de la délivrance du brevet:
**04.11.92 Bulletin 92/45**

(84) Etats contractants désignés:
**DE GB IT NL**

(56) Documents cités:
**EP-A- 0 142 826
US-A- 3 465 127
US-A- 3 875 517**

**ALTA FREOUENZA, vol. 51, no. 1,
janvier/février 1982, pages 43-48; G. BOLLE et
al.: "Stable frequency and low power
consumption quartz oscillator"**

(73) Titulaire: **THOMSON-CSF
51, Esplanade du Général de Gaulle
F-92800 Puteaux(FR)**

(72) Inventeur: **Besson, Yves
THOMSON-CSF SCPI 19, avenue de Messine
F-75008 Paris(FR)**

(74) Mandataire: **Benoit, Monique et al
THOMSON-CSF SCPI
F-92045 PARIS LA DEFENSE CEDEX 67(FR)**

## Description

L'invention concerne de manière générale les oscillateurs à quartz et, plus particulièrement, ceux qui sont asservis en fréquence de manière à osciller à une fréquence déterminée.

Les oscillateurs à quartz sont le plus souvent utilisés pour générer un signal électrique à une fréquence déterminée qui doit être fixe et de grande stabilité. Pour obtenir de telles caractéristiques, le quartz, qui est l'élément de référence pour obtenir un signal de fréquence fixe, doit être taillé avec précision de manière à rendre ces caractéristiques les plus indépendantes possible des variations de température autour d'une valeur de fonctionnement. En outre, il est placé dans une enceinte maintenue à la température de fonctionnement résultant de la taille. C'est le cas dans l'invention revendiquée par le brevet US-A-3 465 127 où deux oscillateurs à quartz fonctionnant à fréquence fixe sont utilisés pour réguler la température à l'intérieur d'une enceinte thermique. Les deux quartz ont en effet des caractéristiques thermiques dont le point d'intersection correspond à la température de régulation voulue. Une régulation thermique associée à une régulation électronique asservit la fréquence d'oscillation de ces deux quartz qui sont à l'intérieur de l'enceinte, à la fréquence d'intersection de leurs caractéristiques thermiques et par là même maintient constante la température correspondante à l'intérieur de l'enceinte. Ainsi ce système ne fonctionne qu'à fréquence fixe.

Dans certaines applications, il serait souhaitable de disposer d'oscillateurs à quartz dont la fréquence de fonctionnement pourrait être décalée aisément sans nuire à leur qualité spectrale de manière, par exemple, à comparer en phase deux signaux fournis par de tels oscillateurs initialement décalés en fréquence.

Pour réaliser ce souhait, une solution consiste à modifier la fréquence d'oscillation d'un ou des deux oscillateurs à quartz par l'intermédiaire d'un élément réactif dans le circuit résonnant dont la valeur est modifiée par une commande électronique. Cet élément réactif est très souvent une diode dite "Varicap" dont la capacité varie en fonction de la tension qui est appliquée à ses bornes. Cette solution présente l'inconvénient d'être limitée à des excursions de fréquence très faibles, d'autant plus faibles que l'on ne veut pas dégrader la qualité spectrale du ou des signaux.

Une autre solution pour effectuer une telle comparaison est d'effectuer des transpositions de fréquence de manière à rapprocher les fréquences à comparer. Les dispositifs pour les mettre en oeuvre sont complexes, manquent de souplesse et sont à l'origine, du fait de leur principe, de l'existence de raies parasites qu'il est parfois difficile d'éliminer, d'où une détérioration de la qualité spectrale.

Un but de la présente invention est donc de réaliser un oscillateur à quartz qui peut être asservi en fréquence dans une large gamme sans dégradation de la qualité spectrale du signal fourni.

Un autre but de l'invention est de réaliser un oscillateur à quartz pour lequel il n'est pas nécessaire d'avoir une taille précise du quartz, ce qui en réduit le coût de manière substantielle.

L'invention se rapporte à un oscillateur à quartz à large bande de fréquence dont le signal de sortie est asservi en fréquence et en phase sur un générateur de fréquence de référence à l'aide d'une régulation électronique du type boucle à verrouillage de phase connue en soi et produisant un signal représentatif de l'écart de phase ou de fréquence entre ledit oscillateur et ledit générateur pour commander un élément réactif variable placé dans le circuit oscillant dudit oscillateur, ladite régulation électronique étant doublée d'une régulation thermique comprenant des moyens de chauffage du quartz de l'oscillateur et des moyens de comparaison pour comparer ledit signal représentatif de l'écart de phase ou de fréquence à une source de tension continue de référence pour fournir un signal de commande des moyens de chauffage de manière à agir sur la température du quartz, caractérisé en ce que ledit générateur de fréquence fournit une consigne de fréquence qui peut être modifiée pour modifier la fréquence d'oscillation de l'oscillateur à quartz en faisant varier le point de fonctionnement en température du quartz au moyen de ladite régulation thermique en fonction de la fréquence de fonctionnement assignée à l'oscillateur par le générateur de manière à réduire l'écart entre la tension continue de référence et ledit signal représentatif de l'écart de phase ou de fréquence produit par ladite régulation électronique et donc à conserver la qualité spectrale en sortie de l'oscillateur sur une large gamme de fréquence de fonctionnement.

La température de fonctionnement du quartz est choisie de manière que la fréquence d'oscillation du quartz corresponde à celle assignée à l'oscillateur et que cette fréquence d'oscillation varie substantiellement avec la température.

D'autres caractéristiques et avantages de la présente invention apparaîtront à la lecture de la description suivante d'un exemple particulier de réalisation, ladite description étant faite en relation avec le dessin joint dans lequel :

- la figure 1 est un diagramme représentant la courbe de variation de la fréquence d'un quartz en fonction de la température;
- la figure 2 est un schéma fonctionnel d'un oscillateur à quartz asservi en fréquence par effet thermique selon des caractéristiques de l'invention, et
- la figure 3 est une vue montrant un exemple de réalisation des moyens de chauffage du quartz de l'oscillateur à quartz.

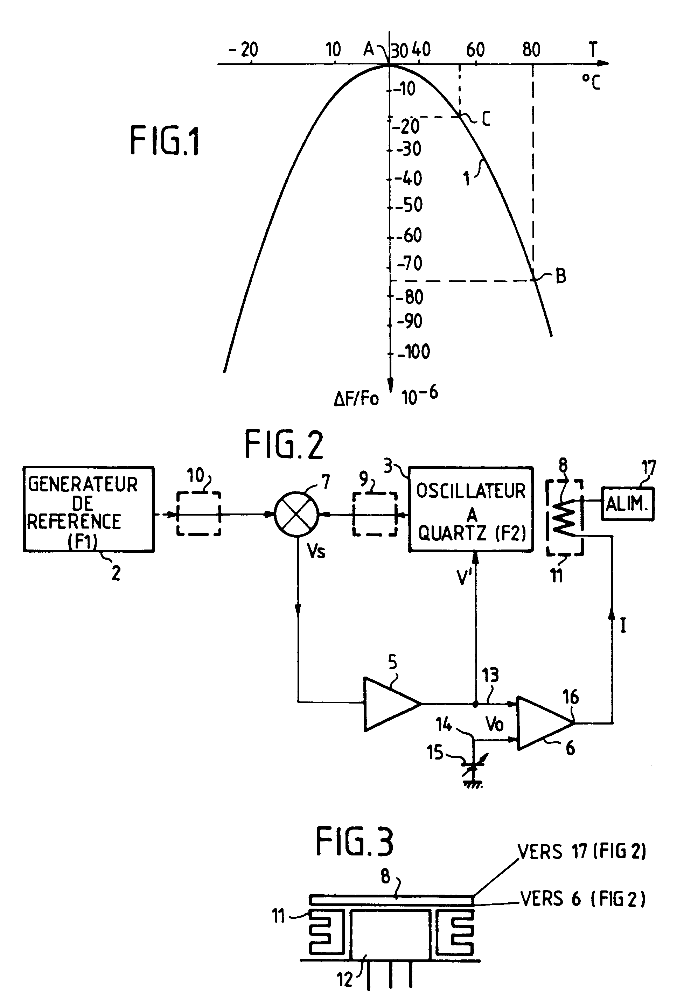

Comme on l'a indiqué dans le préambule, la fréquence d'un oscillateur à quartz est déterminée par celle du quartz qui est utilisé. Or celle-ci varie ou dérive avec la température selon une loi dite de dérive thermique dont on peut relever la (ou les) courbe(s) de variation, ces courbes dépendant du type de coupe du quartz et de l'angle de coupe. C'est ainsi qu'une courbe de variation de la fréquence d'un quartz en valeurs relatives $\Delta F/Fo$ en fonction de la température T a l'allure de celle portant la référence 1 représentée sur la figure 1, la fréquence Fo étant celle du quartz au point d'inversion A c'est-à-dire à la température $T_o$ et $\Delta F$ étant l'écart de fréquence par rapport à Fo.

Dans les oscillateurs à quartz de type classique où l'on recherche la stabilité de la fréquence d'oscillation, on place le point de fonctionnement du quartz en A car, en ce point, l'effet de la température est moindre que pour tout autre point de la courbe. C'est à cette température $T_o$ que le quartz est maintenu en le disposant dans une enceinte régulée en température.

Selon la présente invention, il est proposé de choisir un point de fonctionnement, par exemple B, pour lequel l'effet de la variation de température sur la fréquence du quartz est nettement plus grand qu'au point A. Au point B, qui correspond à une température T = 80°C, la valeur de $\Delta F/Fo$ est égale à $-75.10^{-6}$ en choisissant $T_o = 30°$ C pour le point d'inversion A.

Il est à noter que l'expression mathématique de la courbe 1 est donnée par la formule :

$$\frac{\Delta F}{Fo} = -3.10^{-8} (T-To)^2,$$

To étant la température au point A, soit 30°C pour l'exemple choisi.

Pour un autre point de fonctionnement C correspondant à T = 55°C, on obtient $\Delta F/Fo = -18,75.10^{-6}$, ce qui montre qu'entre les points B et C, la variation moyenne de $\Delta F/Fo$ est $2,25 . 10^{-6}$ par degré alors qu'elle n'est que de $0,75 . 10^{-6}$ par degré entre C et A, soit trois fois moindre.

Selon la présente invention, pour faire varier la fréquence de l'oscillateur à quartz, il est prévu de modifier la température du quartz en lui associant un dispositif de chauffage tel qu'une résistance électrique dont on fait varier le courant d'alimentation en fonction de l'écart de fréquence constaté.

La figure 2 donne le schéma fonctionnel d'un circuit électronique qui permet de réaliser, selon la présente invention, un asservis sement en phase et fréquence par effet thermique.

La référence 3 désigne un oscillateur à quartz à la fréquence F2 qui est asservi en fréquence en mettant en oeuvre des caractéristiques de l'invention. Après multiplication ou division de fréquence par un facteur a dans un circuit approprié 9, le signal de fréquence aF2 ou F2/a est comparé en fréquence dans un comparateur de phase ou fréquence/phase 7 qui reçoit par ailleurs un signal de référence fourni par un générateur de fréquence 2. La fréquence du signal de référence est F1 et il peut être prévu de le multiplier ou de le diviser par un facteur b dans un circuit approprié 10 pour permettre sa comparaison en phase ou en fréquence/phase dans le comparateur 7 avec le signal de fréquence aF2 ou F2/a.

Le comparateur 7 fournit un signal de sortie Vs qui est caractéristique de l'écart de phase ou de fréquence entre les signaux qui lui sont appliqués et ce signal est appliqué par l'intermédiaire d'un amplificateur opérationnel 5, par exemple, à une diode dite "Varicap" (non représentée) qui est connectée dans le circuit oscillant de l'oscillateur à quartz 3. Comme cela est connu, cette diode a la propriété d'avoir une capacité qui varie en fonction de la tension qui est appliquée à ses bornes.

Cette première boucle d'asservissement du type électronique comprenant le comparateur 7, l'amplificateur opérationnel 5 et la diode "Varicap" du circuit oscillant est connue sous l'appellation de "Boucle à verrouillage de phase" ou "Phase lock loop" et ne sera pas décrite de manière plus détaillée. Cette première boucle ne permet un asservissement que pour un écart de fréquence très faible de l'ordre de quelques millionièmes de la fréquence d'oscillation du quartz.

Selon l'invention, une deuxième boucle d'asservissement par effet thermique est associée à la première et utilise un amplificateur opérationnel différentiel 6, une résistance chauffante 8 et un radiateur 11, ces deux derniers éléments étant quant à eux couplés au quartz 12 (figure 3) de l'oscillateur 3 de la manière qui sera décrite en relation avec la figure 3. Cette deuxième boucle a pour but d'effectuer le ralliement en fréquence permettant le verrouillage de phase de l'oscillateur à la fréquence F2 sur le signal de référence à la fréquence F1.

L'amplificateur différentiel 6 a deux entrées, l'une 13 connectée à la sortie de l'amplificateur 5 et l'autre 14 à une source de tension 15 dont la valeur Vo est réglable. Cet amplificateur fournit à sa borne de sortie 16 un courant I dont l'intensité est proportionnelle à l'écart entre la tension Vo de la source 15 et la tension $V'$ appliquée à la diode "Varicap".

Ce courant I traverse la résistance chauffante 8 de manière à élever ou diminuer la température du radiateur 11 et par là-même celle du quartz 12. Alors qu'une extrémité de la résistance chauffante 8 est connectée à la borne de sortie 16 de l'amplificateur opérationnel différentiel 6, l'autre extrémité est, par exemple, connectée à une source d'alimentation 17 de polarité et de valeurs appropriées.

La valeur du courant I s'établit par la boucle de manière que la température de fonctionnement du quartz soit par exemple de 80°C, celle qui rend F2 implicitement voisine de F1, ce qui réduit l'écart entre V′ et Vo pour atteindre le courant nécessaire à l'équilibre thermique qui convient.

Le fonctionnement du circuit de la figure 2 est alors le suivant, en supposant que le système démarre. Initialement le quartz de l'oscillateur est à une température systématiquement trop basse et par conséquent, la fréquence de l'oscillateur se trouve à une valeur supérieure à celle correspondant au point de fonctionnement choisi. L'écart de tension entre V′ et Vo est important et entraîne le débit d'un courant dans l'élément chauffant ce qui entraîne la baisse de fréquence de l'oscillateur à quartz selon la loi de la figure 1. La fréquence de l'oscillateur à quartz se rapproche ainsi de celle du générateur de référence 2, ceci jusqu'à ce que les deux fréquences soient suffisamment voisines pour permettre le verrouillage en phase des deux oscillateurs l'un sur l'autre. Ceci réalisé, la tension V′ est significative des écarts implicites de fréquence entre les deux oscillateurs. Dans ces conditions l'écart de tension V′ - Vo (Vo étant une référence choisie comme point de fonctionnement pour assurer les meilleures conditions pour le bruit de l'oscillateur) est exploité pour assurer l'asservissement thermique de la fréquence de l'oscillateur à quartz.

On voit donc que l'ensemble travaille en deux temps

1. recherche en fréquence par action thermique,
2. verrouillage en phase et asservissement en fréquence simultané par l'action de la boucle thermique afin que la bande de phase travaille autour d'un point de fonctionnement optimal du point de vue du bruit de l'oscillateur à quartz.

Avec un tel circuit, lorsque les deux oscillateurs sont calés sur la même fréquence, les variations de phase sont corrigées par la boucle de phase du type classique; par ailleurs, si la fréquence de l'oscillateur de référence 2 change, la fréquence de l'oscillateur 3 est modifiée par la boucle d'asservissement thermique en changeant la température du quartz, c'est-à-dire en le chauffant plus ou moins selon le sens de la modification à obtenir.

Bien entendu, le schéma de la figure 2 permet de comprendre le principe de l'invention mais on comprend que, en pratique, les deux boucles d'asservissement, et notamment celle mettant en oeuvre l'effet thermique, peuvent être réalisées de différentes façons qui sont toutes du domaine de l'homme de métier. C'est ainsi que la deuxième boucle d'asservissement peut être du type analogique ou du type numérique, qu'elle doit comprendre des filtres de correction nécessaires à la stabilité de la boucle thermique et qu'elle doit prévoir un limiteur du courant de chauffage pour éviter un emballement du système, notamment au démarrage.

Il en est de même des moyens qui peuvent être mis en oeuvre pour chauffer le quartz 12, ces moyens sont aussi à la portée de l'homme de métier sand avoir à faire oeuvre d'invention. Par exemple, sur la réalisation de la figure 3, le quartz 12 est entouré du radiateur 11 et est coiffé de la résistance chauffante 8 qui est en contact thermique aussi bon que possible avec le quartz 12 et le radiateur 11. D'autres arrangements sont évidemment réalisables sans sortir du domaine de l'invention.

L'oscillateur à quartz asservi en fréquence par effet thermique selon l'invention peut être utilisé dans de nombreuses applications telles que :

- la comparaison des bruits de phase d'oscillateurs à quartz pour des mesures de métrologie très faible bruit;
- le calage et la synchronisation de réseaux d'oscillateurs à quartz indépendants sur une référence commune, par exemple en radiodiffusion;
- l'asservissement d'oscillateurs à quartz très haute fréquence et faible bruit mais peu stable à long terme, sur une référence à plus basse fréquence;
- le calage final d'oscillateurs à quartz haute fréquence à ondes de surface réalisés sur substrat de quartz ou autre substrat sensible à la température sur une référence à plus basse fréquence, etc.

Dans les oscillateurs à quartz de type classique, la taille du quartz doit être précise pour que le quartz ait le point d'inversion A comme point de fonctionnement. Une telle précision n'est pas nécessaire dans les oscillateurs à quartz selon l'invention, ce qui entraîne une réduction du coût du quartz.

**Revendications**

1. Oscillateur à quartz à large bande de fréquence dont le signal de sortie est asservi en fréquence et en phase sur un générateur de fréquence de référence (2) à l'aide d'une régulation électronique (5, 7) du type boucle à verrouillage de phase connue en soi et produisant un signal (V') représentatif de l'écart de phase ou de fréquence entre ledit oscillateur et ledit générateur pour commander un élément réactif variable placé dans le circuit oscillant dudit oscillateur, ladite régulation électronique étant doublée d'une régulation thermique comprenant des moyens de chauffage (8, 11) du quartz de l'oscillateur et des moyens de comparaison (6) pour comparer ledit signal représentatif de l'écart de phase ou de fréquence (V') à une source de tension continue de référence (Vo) pour fournir un signal de commande des moyens de chauffage de manière à agir sur la température du quartz (3), caractérisé en ce que ledit générateur de fréquence (2) fournit une consigne de fréquence (F1) qui peut être modifiée pour modifier la fréquence d'oscillation (F2) de l'oscillateur à quartz en faisant varier le point de fonctionnement en température (B) du quartz au moyen de ladite régulation thermique en fonction de la fréquence de fonctionnement assignée à l'oscillateur par le générateur (2) de manière à réduire l'écart entre la tension continue de référence (Vo) et ledit signal (V') représentatif de l'écart de phase ou de fréquence produit par ladite régulation électronique et donc à conserver la qualité spectrale en sortie de l'oscillateur sur une large gamme de fréquence de fonctionnement.

2. Oscillateur à quartz selon la revendication 1, caractérisé en ce que les moyens de chauffage sont commandés par un courant dont l'intensité est commandée par les moyens de comparaison.

3. Oscillateur à quartz selon la revendication 2, caractérisé en ce que les moyens de chauffage comprennent en outre un radiateur (11) couplé thermiquement à la résistance chauffante (8) et au quartz.

## Claims

1. Wide-frequency-band quartz oscillator whose output signal is slaved in frequency and in phase to a reference frequency generator (2) with the aid of electronic regulation (5, 7) of the phase lock loop type which is known per se, and producing a signal (V') representative of the phase or frequency offset between the said oscillator and the said generator in order to control a variable, reactive element placed in the oscillating circuit of the said oscillator, the said electronic regulation being reinforced by thermal regulation comprising means of heating (8, 11) the quartz of the oscillator and comparison means (6) for comparing the said signal representative of the phase or frequency offset (V') to a reference DC voltage source (Vo) in order to supply a control signal for the heating means in such a way as to act on the temperature of the quartz (3), characterised in that the said frequency generator (2) supplies a frequency reference (F1) which can be modified in order to modify the oscillation frequency (F2) of the quartz oscillator by making the operating point of the quartz vary in temperature (B) by means of the said thermal regulation as a function of the operating frequency assigned to the oscillator by the generator (2) in such a way as to reduce the offset between the reference DC voltage (Vo) and the said signal (V') representative of the phase or frequency offset produced by the said electronic regulation and thus to preserve the spectral quality of the output of the oscillator over a large operating frequency range.

2. Quartz oscillator according to Claim 1, characterised in that the heating means are controlled by a current whose intensity is controlled by the comparison means.

3. Quartz oscillator according to Claim 2, characterised in that the heating means further comprise a radiator (11) thermally coupled to the heating resistor (8) and to the quartz.

## Patentansprüche

1. Quarzoszillator mit breitem Frequenzband, dessen Ausgangssignal einem Bezugsfrequenzgenerator (2) mit Hilfe einer elektronischen Regelung (5, 7) vom an sich bekannten Typ der Phasenverriegelungsschleife frequenz- und phasenmäßig nachgeführt wird, die ein Signal (V') erzeugt, das den Phasen- oder Frequenzabstand zwischen dem Oszillator und dem Generator darstellt, um ein im Oszillatorkreis des Oszillators angeordnetes variables reaktives Element anzusteuern, wobei die elektronische Regelung um eine Wärmeregelung ergänzt ist, die Einrichtungen (8, 11) zur Erwärmung des Oszillatorquarzes sowie Vergleichseinrichtungen (6) zum Vergleichen des den Phasen- oder Frequenzabstand darstellenden Signals (V') mit einer Bezugsgleichspannungsquelle (Vo) aufweist, um ein Signal zum Ansteuern der Erwärmungseinrichtung zu liefern, so daß auf die Temperatur des Quarzes (3) eingewirkt wird, dadurch gekennzeichnet, daß der Frequenzgenerator (2) eine Sollfrequenz (F1) liefert, die verändert werden kann, um die Schwingungsfrequenz (F2) des Quarzoszillators durch Ändern des Temperaturarbeitspunktes (B) des Quarzes mit Hilfe der Wärmeregelung in Abhängigkeit von der dem Oszillator durch den Generator (2) zugewiesenen Bezugsfrequenz zu verändern, derart, daß der Abstand zwischen der Betriebsgleichspannung (Vo) und dem Signal (V'), das den von der elektronischen Regelung erzeugten Phasen- oder Frequenzabstand darstellt, verringert und somit die spektrale Qualität am Ausgang des Oszillators über eine große Betriebsfrequenz-Bandbreite aufrechterhalten wird.

2. Quarzoszillator nach Anspruch 1, dadurch gekennzeichnet, daß die Erwärmungseinrichtungen von einem Strom gesteuert werden, dessen Stärke von den Vergleichsmitteln gesteuert wird.

3. Quarzoszillator nach Anspruch 2, dadurch gekennzeichnet, daß die Erwärmungseinrichtungen weiter einen Wärmestrahler (11) umfassen, der thermisch an den Heizwiderstand (8) und den Quarz gekoppelt ist.

## FIG.1

## FIG.2

GENERATEUR DE REFERENCE (F1)

OSCILLATEUR A QUARTZ (F2)

ALIM.

## FIG.3

VERS 17 (FIG 2)

VERS 6 (FIG 2)